# EUROPEAN PATENT APPLICATION

(11) **EP 2 530 444 A1**
(43) Date of publication of application: **05.12.2012**
(21) Application number: 11736675.7
(22) Date of filing: 21.01.2011
(51) Int. Cl.: G01L 9/00, H01L 29/84

(54) **PRESSURE SENSOR**

(30) Priority: 29.01.2010 JP 2010018984
(71) Applicant: Panasonic Corporation, Osaka 571-8501 (JP)
(72) Inventor: NIIMURA, Yuichi, Osaka 540-6207 (JP); NOBE, Takeshi, Osaka 540-6207 (JP); NISIKAWA, Hideo, Osaka 540-6207 (JP); KATO, Fumihito, Osaka 540-6207 (JP)
(74) Representative: Samson & Partner
(86) International application number: PCT/IB2011/000081
(87) International publication number: WO 2011/092563

(57) **Abstract**

A pressure sensor includes: a pressure conversion unit and a signal processing circuit installed in a semiconductor substrate. The pressure conversion unit includes: a diaphragm formed by partially thinning the semiconductor substrate; and a plurality of piezo resistive elements formed on a surface of the diaphragm. The signal processing circuit is constituted by a complementary metal-oxide semiconductor (CMOS) integrated circuit formed in a p-type conductive region disposed around the diaphragm on the surface of the semiconductor substrate, and the piezo resistive elements are provided by forming an n-type conductive region in the p-type conductive region on the surface of the diaphragm by diffusion of n-type impurities and diffusing p-type impurities in the n-type conductive region.

## Description

### Field of the Invention

The present invention relates to a pressure sensor; and, more particularly, to a pressure sensor in which a pressure conversion unit for converting a pressure to an electrical signal and a signal processing circuit for processing the electrical signal obtained by the pressure conversion unit are formed as a single semiconductor substrate.

### Background of the Invention

Conventionally, there are provided various pressure sensors in which a pressure conversion unit consisting of a diaphragm and a piezo resistive element and a signal processing circuit for processing an electrical signal obtained by the pressure conversion unit are installed in a single semiconductor substrate.

For example, in a pressure sensor described in Patent Document 1, a diaphragm and a piezo resistive element are formed in a single crystalline silicon substrate, and a signal processing circuit is installed around the diaphragm. In the related prior art, a manufacturing cost can be reduced by simultaneously performing a process for forming the piezo resistive element and a process for forming the signal processing circuit.
[Patent Document 1] Japanese Patent Application Publication No. H8-87439

Meanwhile, in the prior art described in Patent Document 1, an n-type silicon layer (hereinafter, referred to as "n-type epitaxial silicon layer") is epitaxially grown in a main surface of a p-type single crystalline silicon substrate, and a piezo resistive element formed of a p-type impurity diffusion region is formed in the n-type epitaxial silicon layer. Further, a p well region is formed in the n-type epitaxial silicon layer. An n-channel MOS structure of the signal processing circuit is formed in the p well region, and a p-channel MOS structure is formed in the n-type epitaxial silicon layer. As a consequence, a CMOS integrated circuit is obtained.

However, when the p well region is formed in the n-type epitaxial silicon layer and the n-channel MOS structure is formed in the p well region as in the prior art, the dedicated space of the n-channel MOS structure is increased by the p well region. Or, when the p well region is formed in the n-type epitaxial silicon layer, the concentration of the p well is excessively increased and, thus, the performance of the n-channel MOS structure is lowered.

### Summary of the Invention

In view of the above, the present invention provides a pressure sensor capable of reducing a desiccated space of a signal processing circuit in a semiconductor substrate, and improving performance.

In accordance with an aspect of the present invention, there is provided a pressure sensor including: a pressure conversion unit installed in a semiconductor substrate, for converting a pressure to an electrical signal; and a signal processing circuit installed in the semiconductor substrate, for processing the electrical signal outputted from the pressure conversion unit, wherein the pressure conversion unit includes: a diaphragm formed by partially thinning the semiconductor substrate; and a plurality of piezo resistive elements formed on a surface of the diaphragm, wherein the signal processing circuit comprises a complementary metal-oxide semiconductor (CMOS) integrated circuit formed in a p-type conductive region disposed around the diaphragm on the surface of the semiconductor substrate, and wherein the piezo resistive elements are provided by forming an n-type conductive region in the p-type conductive region on the surface of the diaphragm by diffusion of n-type impurities and diffusing p-type impurities in the n-type conductive region.

With the above configuration, the signal processing circuit is formed in the p-type conductive region formed at the surface around the diaphragm in the semiconductor substrate, and the n-type conductive region is formed in the p-type conductive region by diffusion of n-type impurities. Further, the piezo resistive element is formed by diffusion of p-type impurities into the n-type conductive region. Therefore, the dedicated space of the signal processing circuit in the semiconductor substrate can be reduced and the performance can be improved, compared to the prior art in which both of the piezo resistive element and the signal processing circuit are installed in the n-type conductive region.

In the pressure sensor, a thin film layer which is formed on a surface of the pressure conversion unit in the manufacturing process of the signal processing circuit, may be removed from a region where the piezo resistive elements are not formed.

By doing so, the sensitivity decrease of the pressure conversion unit due to the thin film layer can be suppressed.

Further, in pressure sensor, the thin film layer is also removed from a region where the piezo resistive elements are formed.

Accordingly, the sensitivity decrease of the pressure conversion unit due to the thin film layer can be further suppressed.

A protective film and a stress control film for controlling a stress of the protective film may be formed on the surface of the diaphragm.

With such configuration, the stress applied to the protective film can be offset by the stress of the stress control film.

Further, an insulating thin film layer may be formed on the peizo resistive elements and a conductive thin film layer may be formed on the insulating thin film layer.

Accordingly, the conductive thin film layer serves as a shield and thus can reduce the resistance change of the piezo resistive element which is caused by the external electric field.

Preferably, the conductive thin film layer is electrically connected to a high or a low potential side of a power supply voltage supplied to the signal processing circuit.

Further, the peizo resistive element may be electrically connected to another peizo resistive element and the signal processing circuit through an impurity diffusion region formed on the surface of the substrate, the impurity diffusion region having a resistance lower than that of the peizo resistive element.

With such configuration, the effect of the resistance change of the portions that does not include the piezo resistive element can be reduced, and thereby the detection accuracy can be increased.

The n-type conductive region where the piezo resistive elements are formed may be electrically connected to a high potential side of a power supply voltage supplied to the signal processing circuit.

The pressure conversion unit may be covered by a protective film formed of an insulating thin film.

Accordingly, the pressure conversion unit can be protected electrically, chemically and physically.

### Brief Description of the Drawings

The objects and features of the present invention will become apparent from the following description of embodiments, given in conjunction with the accompanying drawings, in which:
Figs. 1A to 1C are a top view of a pressure sensor in accordance with a first embodiment of the present invention, a side cross sectional view thereof and a cross sectional view of principal parts thereof, respectively;
Fig. 2 is a circuit configuration diagram of a single processing circuit in the first embodiment;
Figs. 3A to 3C are a top view of a pressure sensor in accordance with a second embodiment of the present invention, a partial cross sectional view taken along line A-A in Fig. 3A, and a partial cross sectional view taken along line B-B in Fig. 3A, respectively;
Figs. 4A to 4C are a top view of a pressure sensor in accordance with a third embodiment of the present invention, a partial cross sectional view taken along line A-A in Fig. 4A, and a partial cross sectional view taken along line B-B in Fig. 4A, respectively;
Figs. 5A to 5C are cross sectional views of principal parts in accordance with a fourth embodiment of the present invention, wherein Figs. 5A to 5C are applied to the first to third embodiments, respectively;
Fig. 6 is a cross sectional view showing principal parts of a pressure sensor in accordance with a fifth embodiment of the present invention; and
Fig. 7 is a top view showing a region where a piezo resistive element is formed in a pressure sensor in accordance with a sixth embodiment of the present invention.

### Detailed Description of the Embodiments

Hereinafter, embodiments of the present invention will be described with reference to the accompanying drawings which form a part hereof. Throughout the drawings, like reference numerals refer to like or similar parts, and redundant description thereof will be omitted.

### (First embodiment)

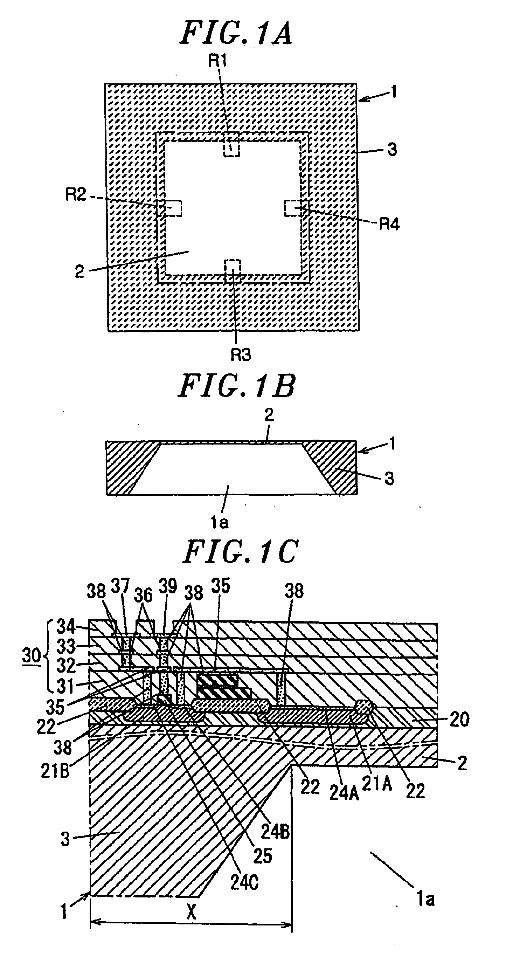

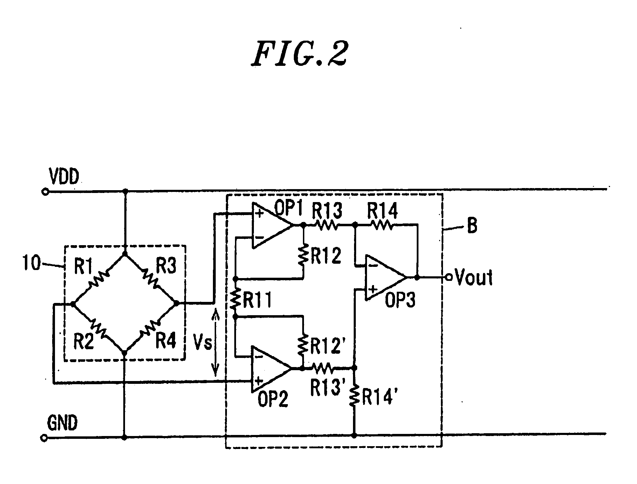

Fig. 1A shows a top view of a pressure sensor of the present embodiment; Fig. 1B illustrates a cross sectional view thereof; and Fig. 1C depicts a cross sectional view showing principal parts thereof. The pressure sensor includes a pressure conversion unit 10 (see Fig. 2) in which four piezo resistive elements (hereinafter, simply referred to as "piezo resistors") R1 to R4 are formed on a main surface side (top surface side in Fig. 1B) of a diaphragm 2 provided in a semiconductor substrate 1, e.g., a single crystalline silicon substrate.

The diaphragm 2 is provided by forming a recess 1a having a substantially truncated pyramid shape when seen from a side surface on a backside of the semiconductor substrate 1 (bottom surface side in Fig. 1B) by using an anisotropic etching technique or the like. Hereinafter, a peripheral portion around the diagphragm 2 having a uniform thickness is referred to as a frame 3 in the semiconductor substrate 1.

The four piezo resistors R1 to R4 are disposed substantially in the middle of each of four sides of the diaphragm 2 in the thickness direction of the semiconductor substrate 1 (vertical direction in Fig. 1B). As shown in Fig. 2, the pressure conversion unit 10 is configured as a bridge circuit of the four piezo resistors R1 to R4.

An output voltage Vs of the pressure conversion unit 10 is amplified by a signal processing circuit B. The signal processing circuit B includes operational amplifiers OP1 and OP2. The operational amplifier OP1 has a non-inverting input terminal connected to one of the output terminals of the pressure conversion unit 10, i.e., the connection node between the piezo resistor R3 and the piezo resistor R4. The operational amplifier OP2 has a non-inverting input terminal connected to the other of the output terminals of the pressure conversion unit 10, i.e., the connection node between the piezo resistor R1 and the piezo resistor R2. The outputs of the two operational amplifiers OP1 and OP2 are differentially amplified by another operational amplifier OP3.

The signal processing circuit B includes the above-described three operational amplifiers OP1 to OP3, resistors R11 to R14, and resistors R12' to R14'. Here, the resistors R12 and R12' are designed to have the same resistance; the resistors R13 and R13' are designed to have the same resistance; and the resistors R14 and R14' are designed to have the same resistance. Further, the pressure conversion unit 10 is connected to a power supply VDD and a ground GND and a pad electrode (not shown) formed on the main surface side of the semiconductor substrate 1 or the like is interposed between them.

Thus, the output voltage Vout of the signal processing circuit B shown in Fig. 2 is obtained by an equation Vout=Vs(1+2R12/R11) × (R14/R13) (Vs being a difference between input voltages applied to the non-inverting input terminals of the operational amplifiers OP1 and OP2). In the signal processing circuit B, the resistors R11 and R12 serves as a temperature compensation circuit in which resistance temperature coefficients of the resistors R11 and R12 are properly, e.g., differently set within the range of about hundreds of ppm to thousands of ppm in accordance with desired sensor characteristics. In the same manner, the resistors R11 and R12' serves as a temperature compensation circuit as well.

In other words, the signal processing circuit B has a function of amplifying the output of the pressure conversion unit 10 and a function of compensating the temperature. The resistors R11 to R14 and the resistors R12' to R14' of the signal processing circuit B consist of diffusion resistors. Further, each of the operational amplifiers OP1 to OP3 is formed of a MOSFET or the like. The above-described function and configuration of the signal processing circuit B are only examples, and another function may be added. Alternatively, the same function may realized by a different circuit configuration.

The signal processing circuit B is constituted by a CMOS integrated circuit formed on the main surface side of the semiconductor substrate 1 by a conventional CMOS process, as shown in Fig. 1C. Moreover, the signal processing circuit B is formed only in a region X corresponding to the frame 3 in the semiconductor substrate 1 (see Figs. 1A and 1C).

As shown in Fig. 1C, the p-type conductive region (e.g., the p-type epitaxial silicon layer) 20 is formed on the entire surface of the semiconductor substrate 1. Then, an oxide film 22 is formed in the p-type conductive region 20 and is patterned. Further, n-type impurity diffusion regions (hereinafter, also referred to as "n-type conductive regions") 21A and 21B are formed in the p-type conductive region 20 where the oxide film 22 is removed by the patterning.

Next, by diffusing p-type impurities in the n-type conductive regions 21A and 21B, a p-type impurity diffusion region 24A serving as the piezo resistors Ri (i=1, 2, 3, 4) is formed in the n-type conductive region 21A, and p-type impurity diffusion regions 24B and 24C serving as a drain region and a source region of the p-type MOSFET are formed in the other n-type conductive region 21B. Moreover, a polycrystalline silicon layer 25 serving as a gate region of the p-type MOSFET is formed on the surface side (upper surface side in Fig. 1C) of the n-type conductive region 21B between the p-type impurity diffusion regions 24B and 24C.

Thus, the piezo resistors R1 to R4 and the signal processing circuit B can be formed at the same time by the CMOS process. Although it is not shown, an n-type MOSFET structure is formed in the p-type conductive region 20. The n-type conductive region 21A where the piezo resistors Ri is formed is connected to a high potential side of the power supply VDD by an interlayer wiring 38 to be described later or the like.

Furthermore, a thin film layer 30 for wiring is formed on the surface side of the p-type conductive region 20. The thin film layer 30 includes a first to a fourth insulating thin film layer 31 to 34 formed of silicon oxide films; a first to a third conductive thin film layer 35 to 37 made of metal thin films formed on the surfaces of the first to the third insulating thin film layer 31 to 33 (the interfaces of the second to the fourth insulating thin film layer); and the interlayer wiring 38 for electrically connecting the first to the third thin film layer 35 to 37. The signal processing circuit B and the piezo resistor Ri are electrically connected to each other through the first conductive thin film layer 35 and the interlayer wiring 38.

In the prior art described in patent document 1, an n-type conductive region (n-type epitaxial·silicon layer) is formed on the main surface side of the p-type semiconductor substrate, and the piezo resistive element and the CMOS integrated circuit are formed in the n-type conductive region. Therefore, the dedicated space of the n-channel MOS structure is increased. Or, when the p well region is formed in the n-type conductive region, the concentration of the p well is excessively increased. As a result, the performance of the n-channel MOS structure is decreased.

To solve such problems, in the present embodiment, the p-type conductive region 20 is formed on the main surface side of the semiconductor substrate 1 and the CMOS integrated circuit is formed in the p-type conductive region 20, as described above. Further, the n-type conductive region 21A is formed in the p-type conductive region 20 by diffusion of n-type impurities, and the peizo resistive Ri is formed in the n-type conductive region 21A by diffusion of p-type impurities. Accordingly, the above problems of the prior art described in patent document 1 can be solved. Moreover, the dedicated space of the signal processing circuit B in the semiconductor substrate 1 can be reduced and the performance can be improved.

### (Second embodiment)

In the first embodiment, the thin film layer 30 is formed on the entire main surface side of the semiconductor substrate 1 including the diaphragm 2. In that case, the following problems may be generated.
1) Since the substantial thickness of the diaphragm 2 is increased by the thin film layer 30, the diaphragm 2 is not easily bent and this results in decrease of the detection accuracy.
2) Since the thin film layer 30 is formed on the piezo resistor Ri such that the piezo resistor Ri is disposed near the middle of the pressure sensor in the thickness direction, the piezo resistor Ri is less bent even by the same pressure compared to the piezo resistor Ri positioned at the surface of the pressure sensor, which deteriorates the detection sensitivity.
3) When the pressure is not applied from the outside, the diaphragm 2 may be bent by any internal stress of the thin film layer 30. This results in a great offset in the output voltage Vs of the pressure conversion unit 10.
4) The output voltage Vs of the pressure conversion unit 10 does not becomes proportional to the pressure applied from the outside due to the internal stress of the thin film layer 30.

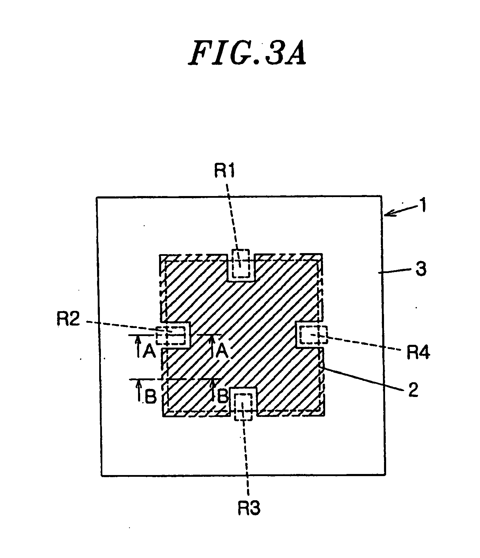

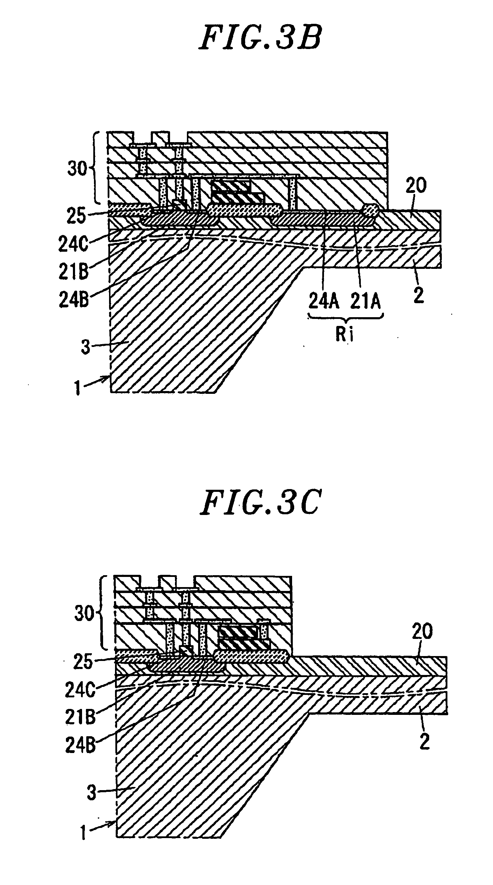

In the present embodiment, among the thin film layer 30 formed on the main surface side of the diaphragm 2, a portion of the thin film layer 30 where the piezo resistors Ri are not formed below (the portion indicated by oblique lines in Fig. 3A) is removed by a proper method such as etching or the like, as shown in Figs. 3A to 3C. That is, in the pressure conversion unit 10, only the portions where the piezo resistors Ri are formed below are covered by the thin film layer 30 as shown in Fig. 3B. As a result, the p-type conductive region 20 is exposed on the main surface side of the diaphragm 2 where the piezo resistors Ri are not formed above, as shown in Fig. 3C.

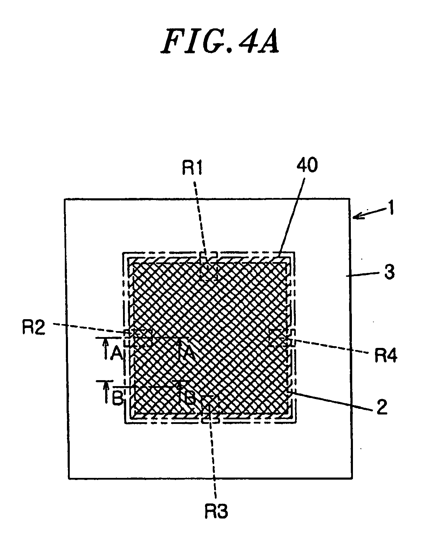

By removing the thin film layer 30 on the main surface side of the diaphragm 2 as the above, the above-described problems 1) to 4) can be solved. In order to protect the diaphragm 2 electrically, chemically and physically, it is preferable to cover the p-type conductive region 20 exposed on the main surface side of the diaphragm 2 by a protective film formed of an insulating thin film (oxide film) as shown in Figs. 4A 4B and 4C to be described later.

### (Third embodiment)

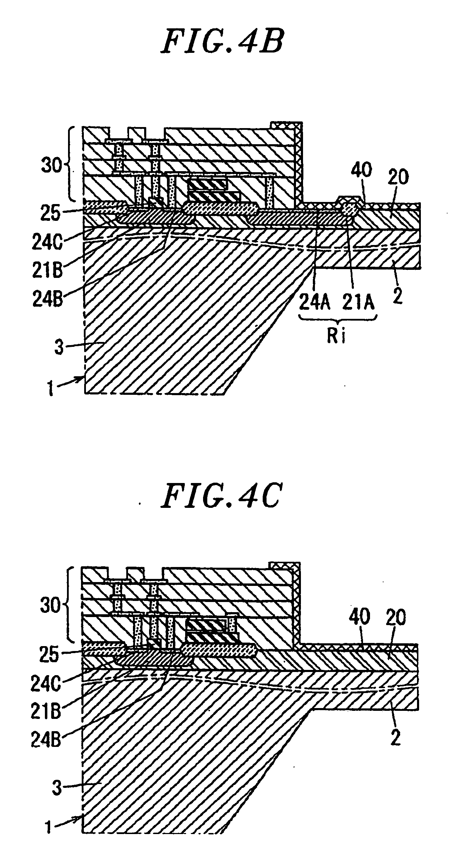

In the second embodiment, among the thin film layer 30 formed on the main surface side of the diaphragm 2, the portion of the thin film layer 30 where the piezo resistors Ri are not formed below has been removed. On the other hand, in the present embodiment, the portion of the thin film layer 30 where the piezo resistors Ri are formed below (the portions indicated by oblique lines in Fig. 4A) is also partially removed on the main surface side of the diaphragm 2, as shown in Fig. 4.

By further removing the thin film layer 30 where the piezo resistors Ri are formed below as described above, the above-described problems 1) and 2) can be further improved. In that case, it is preferable to protect the diaphragm 2, the piezo resistors and the cross section of the thin film layer 30 electrically, chemically and physically, by covering them with a protective film 40 formed of an insulating thin film (oxide film) (see Figs. 4B and 4C).

### (Fourth embodiment)

As described above, when the thin film layer 30 is formed on the main surface side of the diaphragm 2, the compression stress occurs at the insulating thin film layers 31 to 34 of the thin film layer 30.

Thus, 3) even when the pressure is not applied from the outside, the diaphragm 2 is bent due to the internal stress of the thin film layer 30, so that the offset in the output voltage Vs of the pressure conversion unit 10 is increased.

Further, 4) the output voltage Vs of the pressure conversion unit 10 may not be in proportional to the pressure applied from the outside due to the internal stress of the thin film layer 30. The problems 3) and 4) are also caused even by the oxide film 22 interposed between the thin film layer 30 and the p-type conductive region 20.

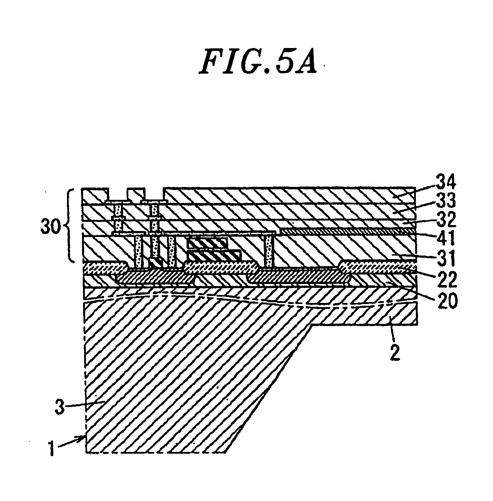

In the present embodiment, in order to set off the compression stress occurring in the insulating thin film layers 31 to 34 of the thin film layer 30 as well as the oxide film 22, a stress control film 41 for generating a tensile stress is formed between, e.g., the insulating thin film layer 31 and the insulating thin film layers 32 to 34 above the diaphragm 2, as shown in Fig. 5A. As for the stress control film 41, a silicon nitride film is used. The tensile stress can be controlled by adjusting the conditions for forming the silicon nitride film or the film thickness thereof.

Further, a stress may occur due to the protective film 40 for protecting the diaphragm 2, the piezo resistors and the cross section of the thin film layer 30 electrically, chemically and physically, it is possible to set off the stress by the stress control film 41 of the present embodiment.

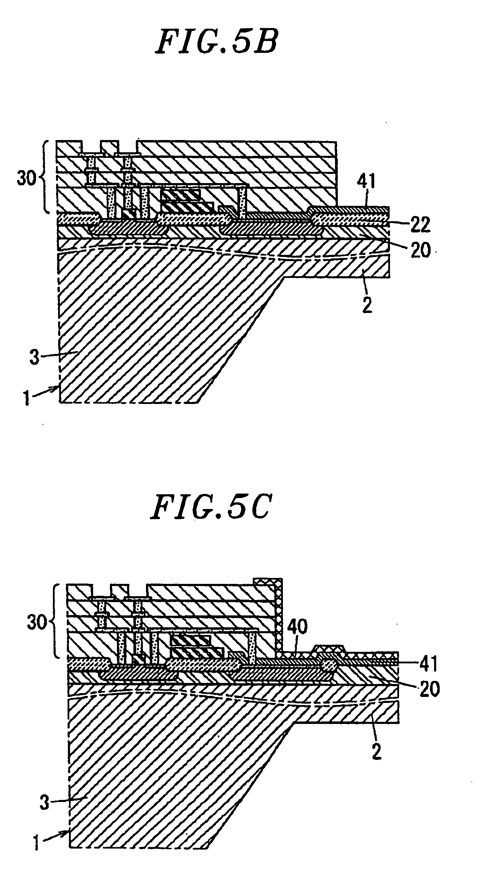

In accordance with the above-described present embodiment, the problems 3) and 4) can be solved by offsetting the compression stress occurring at the protective film 40, the insulating thin film layers 31 to 34 of the thin film layer 30 and/or the oxide film 22 by the tensile stress generated at the pressure control film 41. Moreover, the pressure control film 41 can be applied to the structure of the second embodiment shown in Fig. 5B and the structure of the third embodiment shown in Fig. 5C as well as the structure of the first embodiment shown in Fig. 5A.

For example, the stress control film 41 may be formed below the insulating thin film 31 so as to cover the piezo resistors and the oxide film 22 as shown in Fig. 5B. As shown in Fig. 5C, the stress control film 41 may be formed below the protective film 40 so as to cover the upper side of the piezo resistors, the oxide film 22 and the diaphragm 2.

### (Fifth embodiment)

Meanwhile, when an external electric field (an electric field generated around the power supply line of an external power supply VDD, an external noise or the like) is applied to the peizo resistors Ri of the pressure conversion unit 10, the resistances of the piezo resistors Ri are changed, which may result in a detection error.

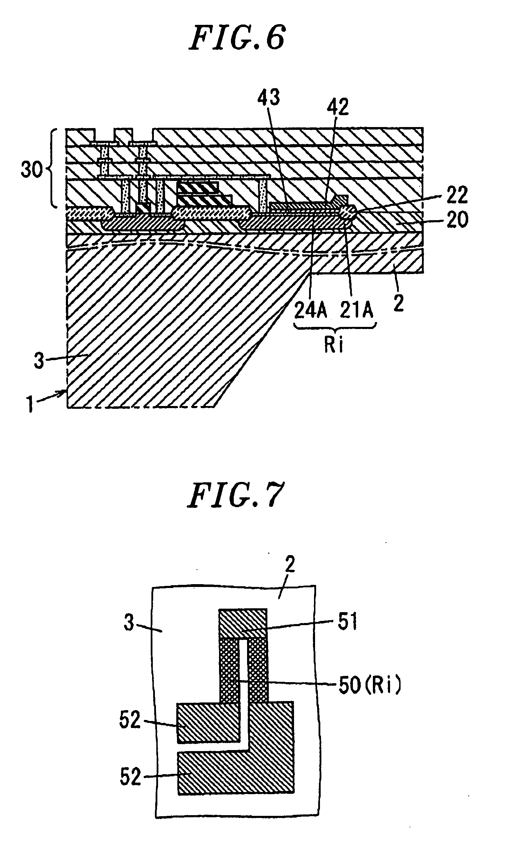

In the present embodiment, the insulating thin film layer 43 is formed on the surface (top surface) of the peizo resistors Ri and the conductive thin film layer 42 is formed on the surface (top surface) of the insulating thin film layer 43, as shown in Fig. 6. Further, the conductive thin film layer 42 is electrically connected to a high potential side or a low potential side (GND) of the power supply voltage VDD feeding the signal processing circuit B.

Thus, since the conductive thin film layer 42 serves as a shield, a change in the resistance of the peizo resistors Ri due to the external electric field can be suppressed, and the detection error of the pressure sensor (output variation) can be prevented. The structure of the present embodiment can be applied to any of the structures of the second to the fourth embodiment as well as the structure of the first embodiment shown in Fig. 6.

### (Sixth embodiment)

As shown in Fig. 7, the actual piezo resistor Ri is formed by connecting one or more piezo resistive elements 50 in series through an interelement connection portion 51 and electrically connecting one or more piezo resistive elements 50 to the signal processing circuit B and power sources (VDD and GND) through a pair of circuit connection portion 52. Here, since the interelement connection portion 51 and the circuit connection portion 52 serve as conduction lines, it is preferred that their resistance changes caused by application of the pressure are small.

To that end, in the present embodiment, the resistances of the interelement connection portion 51 and the circuit connection portion 52 are reduced by setting the impurity concentration of the impurity diffusion region forming the interelement connection portion 51 and the circuit connection portion 52 to be sufficiently higher than the impurity concentration of the piezo resistive elements 50. As a result, the ratio of the resistances of the interelement connection portion 51 and the circuit connection portion 52 to the resistances of the piezo resistors Ri is decreased, so that the detection accuracy of the pressure sensor can be increased. Further, the structure of the present embodiment can be.applied to any of the structures of the first to the fifth embodiment.

While the invention has been shown and described with respect to the embodiments, it will be understood by those skilled in the art that various changes and modification may be made without departing from the scope of the invention as defined in the following claims.

## Claims

1. A pressure sensor comprising:
a pressure conversion unit installed in a semiconductor substrate, for converting a pressure to an electrical signal; and
a signal processing circuit installed in the semiconductor substrate, for processing the electrical signal outputted from the pressure conversion unit,
wherein the pressure conversion unit includes:
a diaphragm formed by partially thinning the semiconductor substrate; and
a plurality of piezo resistive elements formed on a surface of the diaphragm,
wherein the signal processing circuit comprises a complementary metal-oxide semiconductor (CMOS) integrated circuit formed in a p-type conductive region disposed around the diaphragm on the surface of the semiconductor substrate, and
wherein the piezo resistive elements are provided by forming an n-type conductive region in the p-type conductive region on the surface of the diaphragm by diffusion of n-type impurities and diffusing p-type impurities in the n-type conductive region.

2. The pressure sensor of claim 1, wherein a thin film layer which is formed on a surface of the pressure conversion unit in the manufacturing process of the signal processing circuit, is removed from a region where the piezo resistive elements are not formed.

3. The pressure sensor of claim 2, wherein the thin film layer is also removed from at least a part of a region where the piezo resistive elements are formed.

4. The pressure sensor of any one of claims 1 to 3, wherein a protective film and a stress control film for controlling a stress of the protective film are formed on the surface of the diaphragm.

5. The pressure sensor of any one of claims 1 to 4, wherein an insulating thin film layer is formed on the peizo resistive elements and a conductive thin film layer is formed on the insulating thin film layer.

6. The pressure sensor of claim 5, wherein the conductive thin film layer is electrically connected to a high or a low potential side of a power supply voltage supplied to the signal processing circuit.

7. The pressure sensor of any one of claims 1 to 6, wherein the peizo resistive element is electrically connected to another peizo resistive element and the signal processing circuit through an impurity diffusion region formed on the surface of the substrate, the impurity diffusion region having a resistance lower than that of the peizo resistive element.

8. The pressure sensor of any one of claims 1 to 7, wherein the n-type conductive region where the piezo resistive elements are formed is electrically connected to a high potential side of a power supply voltage supplied to the signal processing circuit.

9. The pressure sensor of any one of claims 1 to 8, wherein the pressure conversion unit is covered by a protective film formed of an insulating thin film.
